# EUROPEAN PATENT APPLICATION

(11) **EP 0 544 370 A2**
(43) Date of publication of application: **02.06.1993**
(21) Application number: 92203580.3
(22) Date of filing: 20.11.1992
(51) Int. Cl.: G11C 7/00, G11C 8/00

(54) **Circuit structure having distributed registers with self-timed reading and writing operations**

(30) Priority: 28.11.1991 IT MI913187
(71) Applicant: SGS-THOMSON MICROELECTRONICS S.r.l., I-20041 Agrate Brianza (Milano) (IT)
(72) Inventor: Moloney, David, I-20010 Cornaredo (Milano) (IT); Vai, Gianfranco, I-27100 Pavia (IT); Zuffada, Maurizio, I-20153 Milano (IT); Betti, Giorgio, I-20129 Milano (IT); Sacchi, Fabrizio, I-27100 Pavia (IT)
(74) Representative: Mittler, Enrico

(57) **Abstract**

The circuit structure comprises a series of storage units (11), a data bus (14), an address bus (15), a line (16) for a reading/writing signal, a precharge logic (17) suitable for precharging the address bus with a precharge address and a precharge sensor (18) suitable for enabling the operation of address decoders (12) of the storage units (11) with a given delay with respect to the end of the precharge. The structure also comprises a flip-flop (19) for controlling the address buses (15) and the precharge logic (17) and a dummy storage circuit (20) suitable for producing a stop-writing signal (FS) with a delay calculated on the basis of the time necessary for the writing of a datum in a storage register (13) of said storage units (11).

## Description

The present invention relates to a circuit structure having distributed registers with self-timed reading and writing operations.

A system having distributed registers comprises essentially a series of data storage units, a data bus, an address bus and a line for a reading/writing signal.

Each storage unit consists of a data writing and reading register and of a local address decoder.

If the local address decoder associated with a given register senses the address of the correspondiong register on the address bus, in the case where a writing signal is active the datum on the data bus is transferred into the register, in the case where a reading signal is active the datum stored in the register is transferred to the data bus.

This type of architecture has some drawbacks.

If the local address decoders are faster than the stabilization time of the address on the address bus, it is possible that an incorrect address is decoded.

In the case of a writing operation this implies that a datum is transferred to a register that is not addressed, in the case of a reading operation that a datum from a register that is not addressed is transferred to the data bus.

Moreover, this architecture requires that the registers are accomplished as master-slave flip-flops with a larger size and a higher power consumption than the gate-controlled single stage flip-flops.

In fact in master-slave flip-flops the transfer of a datum from input to output takes place only at the upward (or downward) leading edge of the switching impulse.

But in single-step flip-flops, so long as the switching impulse is present, each change in the state of an input datum is transferred to output. Thus if the datum changes again before the end of the switching impulse, the new state is also transferred to output with the result that, once the operation is completed, the output of the flip-flop is in general again in the initial state, that is, it has not stored the information.

An alternative architecture that solves the problems of address decoding errors provides for an address of an address bus be reserved for a precharge state wherein all the address bus lines are forced to a known and otherwise unused state.

There are thus a precharge logic suitable for precharging the address bus to the precharge address, and a precharge sensor suitable for checking the state of precharge or otherwise on the lines of the address bus.

In the case wherein the address bus is formed by n lines, only 2n - 1 registers may be addressed. The free available address, generally the one with all '1' or all '0', is the one to which the lines of the address bus are precharged.

At the moment when a given register to be subjected to writing or reading is addressed, the precharge state comes to an end and the precharge sensor output, suitably delayed, is then used to enable the local address decoders, as it indicates that the state of the address bus, and thus the address, is stable and can be decoded. In this way one is certain that the datum is read or written only in the addressed register. It is important to arrange the precharge sensor at the extremity of the address bus so as to ensure maximum delay. In this way the certainty exists that the address is stable when the precharge sensor changes state.

The use of the precharge sensor, if on the one hand it solves the problem of the correct register address, it in any case requires the use of master-slave flip-flops as registers in the storage units.

One solution that allows the use of gate-controlled single-stage flip-flops requires, in addition to the precharge sensor, the use of a specific suitably-timed switching or gating signal. The gating signal is obtained as the logic combination of the signal at output of the precharge sensor with the clock signal that also enables the datum switchings. In this way, since the clock signal changes state half-way through the time of duration of the datum, the certainty is ensured that the gating signal, that started with the sensing of the end of precharging after the datum has been switched, ends before the new switching operation of the datum itself and that the datum is question is thus transferred on the output of the flip-flop even if it is of the single-step type.

This solution, if on the one hand it allows the use of single-step flip-flops and can thus be accomplished with a smaller size and a reduced power consumption, does in any case have the drawback that it requires the use of an additional gating signal, that may not be immediately available and that in any case increases the consumption of power.

In addition, such an architecture requires a detailed knowledge of the behaviour of the components of the system in the writing chain, for example, bus delays, decoding delays, etc., in order to determine the minimum length of the gating impulse.

Lastly, this type of architecture does not allow the highest possible rate of operation of a circuit structure accomplished with a mass-production technology and in variable environmental conditions, meaning that the structure is inelastic and operates at the maximum guaranteed rate to obtain proper operations under the worst conditions.

The object of the present invention is to accomplish a circuit structure having distributed registers that guarantees maximum reliability in the operations for addressing the registers and for data writing and reading without requiring master-slave flip-flops and without the use of auxiliary signals.

According to the invention such object is attained through a circuit structure having distributed registers, comprising a series of storage units each consisting of an address decoder and of a datum storage register, a data bus, an address bus, a line for a reading/writing signal, a precharge logic suitable for precharging the address bus with a precharge address and a precharge sensor suitable for enabling the operation of the address decoder of all the storage units with a given delay with respect to the end of the precharge, characterized in that it comprises a flip-flop for controlling the address buses and the precharge logic set by a start-writing signal and reset by a stop-writing signal and a fictitious delay circuit activated by said start-writing signal and enabled by said precharge sensor to produce said stop-writing signal with a delay calculated on the basis of the time necessary for the writing of a datum in a storage register of said storage units.

In particular the fictitious delay circuit, preferably constituted by a fictitious storage unit identical with the data storage units, is suitable for producing said stop-writing signal with a delay calculated on the basis of the time necessary for writing a logic level '1' or a logic level '0' in respective storage registers of the storage units.

This allows the writing operation of the data in the registers to be enabled only for the time necessary to write the datum in the addressed register.

The features of the present invention shall be made more evident by the following detailed description of its embodiments illustrated as non-limiting examples in the enclosed drawings, wherein:
Fig. 1 illustrates a first embodiment of the circuit structure according to the invention;
Fig. 2 illustrates the curve against time of various signals in the circuit structure of Fig. 1 during a reading/writing operation;
Fig. 3 illustrates a second embodiment of the circuit structure according to the invention;
Fig. 4 illustrates in greater detail the circuit structure of said first embodiment.

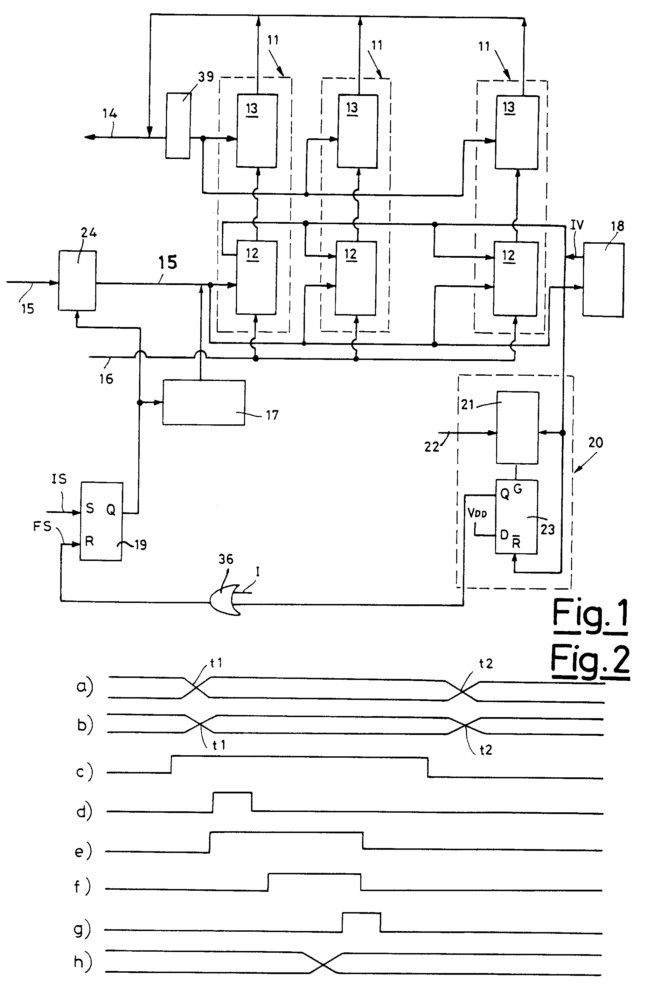

With reference to Fig. 1, a possible circuit structure according to the present invention comprises a series of storage blocks 11, each consisting of an address decoder 12 and of a data storage register 13 enabled by the output signal of the respective address decoder 12.

The storage units 11 are aligned along a data bus 14 and an address bus 15 provided with respective buffers 39, 24. At the extremity of the address bus there is connected a precharge sensor 18 used to emit a valid address signal IV that enables the address decoder 12.

Each storage unit 11 is also connected to a circuit line 16 supplied with a reading/writing signal (the writing signal is obtained by negation of the reading signal). To the address bus 15, at the output of the buffer 24, there is connected a precharge logic 17 suitable for precharging the output of the buffer 24 with a precharge address, say, with all logic values '1'.

The structure also comprises a flip-flop 19 for controlling the address bus 15 and the precharge logic 17. The output of the flip-flop 19 is connected to the buffer 24 and to the precharge logic 17, the set input is connected to a supply line of a start-writing signal IS and the reset input is connected to a supply line of a stop-writing signal FS supplied by an OR logic gate 36 with inputs represented by a power-on reset signal I and by the output of a fictitious delay circuit 20.

The fictitious delay circuit 20 comprises an address decoder 21 connected at output to the precharge sensor 18 and provided with an always-active address input 22. The output of the address decoder 21 is connected at input to a flip-flop 23. The flip-flop 23 is also connected at its reset input to the output of the precharge sensor 18. The output of the flip-flop 23 represents one of the two inputs of the OR logic gate 36. The address decoder 21 and the flip-flop 23 are altogether identical with the address decoder 12 and with the address register 13 of any storage unit 11, so as to introduce identical delays.

With reference to Fig. 2, a) represents the delay of the data on the data bus; b) represents the delay of the addresses on the address bus; c) represents the reading/writing signal; d) represents the start-writing signal; e) represents the precharge end signal and the consequent enabling of the precharging of the addresses on the address bus, at the output of the precharge logic 17; f) represents the valid address signal emitted by the precharge sensor at the end of the precharge operation; g) represents the stop-writing signal; h) represents the delay of the contents of the storage register.

The operation of the circuit structure of Fig. 1 shall now be described with reference to the operation of writing a datum in a register. The operation of reading is different from that of writing only in the fact that the datum, instead of being transferred from the data bus into a register, follows the opposite path, but as regards the operation of correctly addressing of a register 13 inside a storage unit 11 and of delaying the operation it is perfectly similar to the operation of writing and shall not therefore be repeated.

Let us suppose that the operation is to be performed of writing a datum in a register 13.

On the line 16 a corresponding writing signal is sent (Fig. 2c). Let us further suppose that we are in the time interval ranging from t1 to t2 in Fig.s 2a and 2b as regards the delay on the data bus and on the address bus.

The operation of writing a datum in a register 13 is started by means of an impulse of the start-writing signal IS illustrated in Fig. 2d, that is suitably delayed with respect to the writing/reading signal of Fig. 2c and has the object of setting the flip-flop 19. The output of the flip-flop 19 (Fig. 2e) disables the precharge logic 17 and drives the buffer 24 of the address bus 15 to charge on the address bus the address of the register 13 in which the datum is to be stored.

As long as the precharge sensor 18 detects the precharge state on the output of the buffer 24, it keeps the address decoders 12 disabled.

After a given delay certainly higher than the stabilization time of the address on the address bus 15, the precharge sensor 18 senses a state of the address bus 15 different from the precharge and enables through a valid address signal IV (Fig. 2f) the address decoders 12 to decode the address that is now valid on the address bus 15.

Simultaneously the precharge sensor 18 enables the address decoder 21 in the fictitious delay circuit 20, which is in any case always addressed and resets the flip-flop 23.

The output of the address decoder 21 represents the switching impulse of the flip-flop 23, that switches to logic level '1' after the corresponding switching time, equal to that of any register 13 even in the worst case.

The output of the flip-flop 23 and thus of the fictitious delay circuit 20 is combined with the power-on reset signal at input to the OR logic gate 36 and the output of the logic gate 36 is supplied to the reset input of the flip-flop 19 as the stop-writing signal FS (Fig. 2g).

Simultaneously the precharge logic 17 is enabled to charge the precharge address on the address bus 15. Just before this signal the contents of the register 13 that has been addressed changes in the manner illustrated in Fig. 2h.

In the case of the circuit embodiment illustrated above the impulse of the stop-writing signal FS takes place after a time necessary for writing a logic level '1' in the flip-flop 23. In this way one is certain that in the addressed register 13 the writing of a datum has been completed, in the specific case of a logic level '1'.

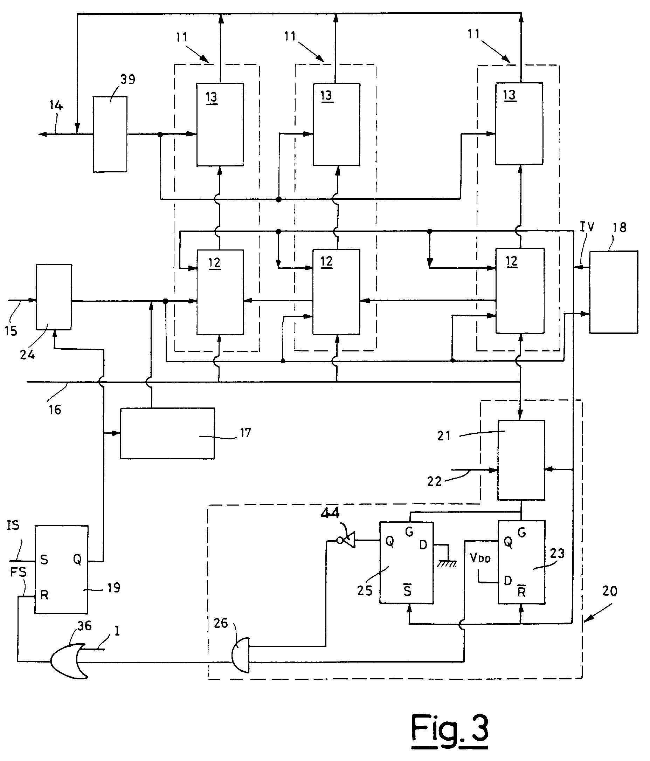

An embodiment of a circuit structure that is alternative to that of Fig. 1 and more complete is shown in Fig.3 and provides that in the fictitious delay circuit 20 there is a further flip-flop 25. The function of this flip-flop 25 is that of calculating the time necessary to write a logic level '0' in an addressed register 13.

Thus in a manner parallel to the setting of the flip-flop 23 the precharge sensor 18 resets the flip-flop 25. The output of the decoder 21 drives, in addition to the switching of the flip-flop 23 to the logic level '1', that of the flip-flop 25 to the logic level '0'.

The output of the flip-flop 25 is negated by an inverter 44 and then combined with the output of the flip-flop 23 at input to an AND logic gate 26 and the output of this logic gate is combined with a power-on reset signal I at the input of the OR logic gate 36 and the output of the logic gate 36 is supplied to the input reset of the flip-flop 19.

According to this second embodiment the impulse of the stop-writing signal FS takes place after a time necessary to write a logic level '1' in the flip-flop 23 and simultaneously a logic level '0' in the flip-flop 25. In this way one is certain that in the addressed register 13 the writing of a datum has been completed, in the specific case of any logic level.

Both the circuit structures described above are asynchronous and do not require an a priori knowledge of the intrinsic delays. The structures guarantee a reliable operation under all conditions of temperature, power supply, scale of production. Such structures may be associated with synchronous and asynchronous systems.

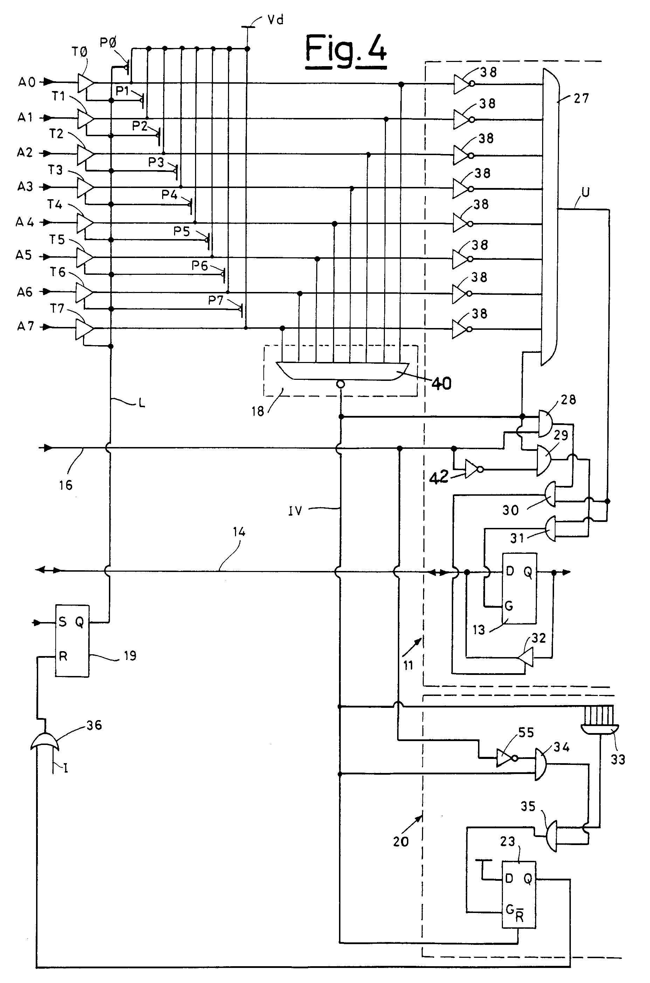

A detailed embodiment of the circuit structure of the first embodiment, limited to a storage unit 11, is illustrated in Fig. 4.

In it A0-A7 indicate the inputs of the lines of the address bus 15, T0-T7 are tristate buffers corresponding as a whole to the buffer 24 of Fig.s 1 and 2. P0-P7 are p-channel MOS transistors. The gates of the transistors P0-P7 are connected to a line L supplied with the signal enabling the charge of the addresses on the address bus 15, that is illustrated in Fig. 2e. As long as such signal is low, the gates of transistors P0-P7 are low. Such transistors conduct and charge the address lines of the address bus 15 to a voltage Vd corresponding to a logic level '1'.

When the signal enabling the charge of the addresses on the address bus goes high, the transistors P0-P7 are interdicted and simultaneously T0-T7 go into conduction and transfer the address on the inputs A0-A7 on the lines of the address bus 15.

The precharge sensor 18 is made with a NAND logic gate 40. The inputs of the gate 40 are the address lines of the address bus 15, the output is the valid address signal IV illustrated in Fig. 2f. Such output is at logic level '1' if at least one of the lines of the address bus 15 is at logic level '0', since in the specific case it has been assumed that the precharge state is represented by all logic levels '1' on the lines of the address bus 15.

At input to each storage unit 11 there is an AND logic gate 27. One of the inputs of the logic gate 27 is represented by a valid address signal IV, the others are connected to the corresponding lines of the address bus 15. At each of the inputs of the logic gate 27 connected to a corresponding line of the address line 15 there is or there is not an inverter 38 according to whether the logic level of the address of the storage unit 11 at said input is '0' or '1'. The case is illustrated in the figure wherein the address of the storage unit 11 is formed by all logic levels '0'. In this way in the case wherein the address on the address bus 15 coincides with that of the storage unit 11, and the valid address signal IV at output from the precharge sensor 18 is at level logic '1', the output U of the unit 11 shall be at logic level '1'.

The storage unit 11 also comprises an AND logic gate 28 with the inputs connected to the line 16 supplying, in this case, a reading signal and to the output of the precharge sensor 18. The output of the AND logic gate 28 represents one of the two inputs of an AND logic gate 30. The other input is represented by the output u of the logic gate 27. At output from the logic gate 30 there is in this way a signal for the validation of the reading operation.

The storage unit 11 also comprises an AND logic gate 29 with the inputs connected to the line 16 supplying, in this case, a writing signal (corresponding to the reading signal negated through an inverter 42) and to the output of the precharge sensor 18. The output of the AND logic gate 29 represents one of the two inputs of an AND logic gate 31. The other input is represented by the output u of the logic gate 27. At output from the logic gate 31 there is in this way a signal for the validation of the writing operation.

The output of the AND logic gate 30 is suitable for enabling a tristate buffer 32 to allow the transfer of the contents of the storage register 13 on the data bus 14; the output of the logic gate 31 is suitable for generating a driving impulse for the transfer into the register 13 of the datum on the data bus 14.

The fictitious delay circuit 20 comprises an AND logic gate 33 which, in the case wherein one is in a state other that of precharge, has the function of introducing a delay having a number of inputs equal to the number of lines of the address bus, represented at output by the precharge decoder 18.

The circuit 20 also comprises an AND logic gate 34 with inputs connected to the line 16 for supplying a writing signal (corresponding to the reading signal negated through an inverter 55) and to the output of the precharge decoder 18. The output of the AND logic gate 34 represents one of the two inputs of an AND logic gate 35. The other input of the logic gate 35 is represented by the output of the logic gate 33. At output from the logic gate 35 there is in this way a signal for the validation of the writing operation.

Such signal is suitable for generating the driving impulse for the writing of a logic level '1' in the register 23 previously reset by the valid address signal IV in a manner altogether similar to what has been illustrated earlier.

The output of the register 23 represents one of the two inputs of the logic gate 36, the other input is represented, as said earlier, by the power-on reset signal I.

## Claims

1. Circuit structure having distributed registers, comprising a series of storage units (11) each consisting of an address decoder (12) and of a datum storage register (13), a data bus (14), an address bus (15), a line (16) for a reading/writing signal, a precharge logic (17) suitable for precharging the address bus with a precharge address and a precharge sensor (18) suitable for enabling the operation of the address decoder (12) of all the storage units (11) with a given delay with respect to the end of the precharge, characterized in that it comprises a flip-flop (19) for controlling the address buses (15) and the precharge logic (17) set by a start-writing signal (IS) and reset by a stop-writing signal (FS) and a fictitious delay circuit (20) activated by said start-writing signal (IS) and enabled by said precharge sensor (18) to produce said stop-writing signal (FS) with a delay calculated on the basis of the time necessary for the writing of a datum in a storage register (13) of said storage units (11).

2. Circuit structure according to claim 1, characterised in that said fictitious delay circuit (20) is constituted by a fictitious storage unit identical with the data storage units (11).

3. Circuit structure according to claim 2, characterised in that said fictitious delay circuit (20) is constituted by a further address decoder (21) identical with the address decoders (12) of the data storage units (13) and provided with an enabling input connected to the output of the precharge sensor (18) and with an always-active address input and with a flip-flop (23), identical with the storage registers (13) of the data storage units (11), having a switch operating input connected to the output of said further address decoder (21) and a reset input connected to the output of the precharge sensor (18), so that said stop-writing signal (FS) is produced with a delay equal to the time necessary for writing in it a logic level '1'.

4. Circuit structure according to claim 1, characterised in that said fictitious storage unit (20) is constituted by a further address decoder (21) identical with the address decoders (12) of the data storage units (13) and provided with an enabling input connected to the output of the precharge sensor (18) and with an always-active address input, by a first and second flip-flop (23, 25) identical with the storage registers (13) of the data storage units (11), having respective switch operating inputs connected to the output of said further address decoder (21) and respective reset and set inputs connected to the output of the precharge sensor (18), the outputs of said flip-flops (23, 25) being combined at the input of an AND logic gate (26) so as to produce at the output of the latter said stop-writing signal (FS) with a delay calculated on the basis of the time necessary for writing logic levels '1' and '0' in the respective flip-flops (23, 25).
